(19) Europäisches Patentamt
European Patent Office
Office européen des brevets

(11) Publication number: **0 260 516**
**A1**

(12) **EUROPEAN PATENT APPLICATION**

(21) Application number: **87112664.5**

(51) Int. Cl.[4]: **C23C 18/16** , C23C 18/30

(22) Date of filing: **31.08.87**

(30) Priority: **15.09.86 US 907277**

(43) Date of publication of application:
**23.03.88 Bulletin 88/12**

(84) Designated Contracting States:
**DE FR GB IT NL**

(71) Applicant: **GENERAL ELECTRIC COMPANY**
**1 River Road**
**Schenectady New York 12305(US)**

(72) Inventor: **Cole, Herbert Stanley, Jr.**
**10 Sandalwood Lane**
**Scotia New York 12302(US)**
Inventor: **Liu, Yung Scheng**
**101 Woodhaven Drive**
**Scotia New York 12302(US)**
Inventor: **Philipp, Herbert Reynold**
**2 Barry Lane**
**Scotia New York 12302(US)**

(74) Representative: **Catherine, Alain et al**
**General Electric France Service de Propriété Industrielle 18 Rue Horace Vernet B.P. 76**
**F-92134 Issy-les-Moulineaux Cedex(FR)**

(54) **Photoselective metal deposition process.**

(57) Metal is deposited on a substrate by irradiating at least a portion of the substrate in the presence of a catalytic metal-containing compound with radiation sufficient to decompose the catalytic metal-containing compound and thereby deposit the catalytic metal on the substrate, and then contacting the catalytic metal with an electroless plating solution containing the metal to be deposited on the substrate. Products produced by the method are useful in the manufacture of electronic components including printed circuit boards, semiconductor devices and the like.

EP 0 260 516 A1

# PHOTOSELECTIVE METAL DEPOSITION PROCESS

## Field of the Invention

The present invention is directed to plating fine lines of metal on a substrate and, more particularly, to depositing a metal on a substrate by photochemically or pyrolytically decomposing a catalytic metal-containing compound by laser irradiation so as to deposit a thin layer of metal catalyst on the target area which is then contacted with an electroless plating solution. The invention finds utility in the manufacture of printed circuit boards, semiconductor devices and the like, and also encompasses products produced by the process.

## Background of the Invention

The use of ultraviolet radiation to decompose an organometallic compound is known in the art (e.g., "Laser Chemical Vapor Deposition of Gold", Baum et al., Appl.Phys.Lett. 47(5) September 1, 1985; "Laser Chemical Vapor Deposition of Copper", F.A. Houle et al., Appl.Phys.Lett. 46(2), January 15, 1985; "Laser Induced Metal Deposition from Organometallic Solution", H. Yokoyama et al. Appl.Phys.Lett. 44(8), April 15, 1984; and "Laser-initiated Deposition Reactions: Microchemistry in Organogold Polymer Films", M.E. Gross et al., Appl.Phys.Lett. 47(9), November 1, 1985). Such processes typically employ laser radiation to either photochemically or pyrolytically decompose the organometallic compound to directly deposit the metal onto the surface of a substrate. Photochemical decomposition generally involves exposing the organometallic compound in the form of a volatile gas to radiation at a wavelength that is absorbed by the gas under the temperature conditions of the reaction. The molecules of the gas dissociate and thereby deposit metal on the substrate in accordance with the pattern defined by the focused laser beam.

Pyrolytic or thermal decomposition takes place by irradiating the substrate in prescribed patterns to thereby heat the substrate to a temperature sufficient to decompose the gaseous compound in proximity of the target area. In this process, the gas does not absorb energy at the wavelength of the laser beam because decomposition is effected by heat exchange at the substrate surface and not by excitation of the gaseous molecules by the laser beam. A detailed explanation of the principles of photochemical and pyrolytic decomposition is disclosed in "Laser Generated Microstructures", Y. Rytz-Froidevaux, Appl.Phys.A 37, pp. 121-128, 1985, incorporated herein by reference.

In many applications for production of electronic components such as printed circuits, semiconductor devices and the like, it is desirable to provide relatively thick layers of metal on the substrate (i.e., on the order of several microns). However, the aforementioned processes may not be suited for making thick deposits of metal because the deposition rate is slow. Furthermore, thick layers of metal deposited in this manner invariably include impurities such as carbon by-products, which adversely affect conductivity.

A further disadvantage of the aforementioned processes is that plastic substrates may not be used when the energy employed to irradiate the gas or heat the substrate is sufficient over time to decompose the plastic. In such case, irradiation of organometallic compounds for the direct deposit of a metal on a plastic substrate is not commercially viable.

It is therefore an object of the invention to provide a method of depositing a metal on a substrate, especially thick deposits of metal on the order of at least several microns.

It is a further object of the invention to provide a rapid means of depositing metal on a substrate, especially plastic substrates.

It is still another object of the invention to provide metal-plated substrates which are useful in production of printed circuits, semiconductor devices and the like.

## Summary of the Invention

The present invention is directed to a method of depositing a metal on a substrate comprising:

(a) irradiating at least a portion of the substrate in the presence of a volatile catalytic metal-containing compound with a sufficient amount of radiation to decompose the catalytic compound and thereby selectively deposit an amount of the catalytic metal on the substrate sufficient to instigate deposition of metal from an electroless plating solution; and

(b) contacting the catalytic metal-coated portion of the substrate with an electroless plating solution containing the metal to be deposited, to thereby deposit the metal on the substrate.

The present invention is also directed to products produced by the above-described method which are useful as electronic components, including printed circuit boards, semiconductor devices and the like.

Brief Description of the Drawings

The features of the invention believed to be novel are set forth with particularity in the appended claims. The invention itself, however, both as to organization and method of operation, together with further objects and advantages thereof, may best be understood by reference to the following description taken in conjunction with the accompanying drawings in which:

Figures 1(a)-1(c) are diagrammatic, sectional views showing sequential steps of one embodiment of the invention wherein metal is deposited directly on the substrate;

Figures 2(a)-2(c) are diagrammatic, sectional views showing sequential steps of another embodiment of the invention wherein metal is deposited on an insulative layer overlaying the substrate; and

Figure 3 is a graph showing the absorbance spectrum for a volatile palladium compound employed in the present invention.

Detailed Description of the Invention

In Figures 1(a)-1(c), substrate 2 is generally any substrate suitable for receiving electrolessly plated metal or which can have thereon an insulative layer for receiving the metal. It is preferred that the substrate 2 comprise a dielectric or microcircuit material. Suitable substrates include one or more of ceramics, polyimides, alumina, silicone polyimides, silicon, silicone rubbers, silicon dioxide, metals (e.g., tungsten, molybdenum, chromium and aluminum) and the like. The substrate may alternatively have thereon a metal pad which can be adapted to provide an interconnection between, for example, printed circuit patterns.

Substrate 2 is placed in an enclosable reaction vessel (not shown) such as a stainless steel cell fitted with a quartz window. The substrate is positioned within the reaction vessel so that it can be selectively irradiated through the window. The reaction vessel is provided with a volatile catalytic metal-containing compound 4 (e.g., a palladium compound) which is irradiated at a substrate target area 6 with radiation (e.g., ultraviolet radiation) designated by reference numeral 8, to thereby decompose the volatile compound into a layer of catalytic metal 10 (palladium in this example) to produce a metallized substrate 12 as shown in Figure 1(b). As used herein, the term "volatile" means a compound which is in the gaseous state under the conditions of irradiation.

Metallized substrate 12 is next contacted with an electroless plating solution containing the metal to be deposited, resulting in formation of a deposit of metal 14 on substrate 2 in target area 6.

The catalytic metal-containing compound may be selected from any compound which contains a metal capable of instigating the deposit of metal when contacted by an electroless plating solution. Such compounds desirably have a reasonably high vapor pressure (typically at least about 1 Torr and preferably about 1-100 Torr) at temperatures below the decomposition temperature of the compound. Additionally, if the compound is to be photochemically decomposed, it must be able to absorb the radiation applied to the reaction vessel.

The volatile catalytic metal-containing compounds which may be employed in the present invention include compounds containing Group VIII metals as well as other metals such as copper, gold, tin, zinc, cadmium, lead and alloys thereof. Examples of such compounds include rhodium tris (hexafluoroacetylacetone) (vapor pressure ~ 10 Torr at about 110°C), iron (III) heptafluorodimethyloctanedionate (vapor pressure ~ 1 Torr at about 140°C), copper (II) heptafluorodimethyloctanedionate (vapor pressure ~ 1 Torr at about 125°C), copper (II) hexafluoroacetylacetonate (vapor pressure ~ 1 Torr at about 85-90°C), dimethyl cadmium, bis (cyclopentadienyl) iron, tetramethyl tin, tetraethyl tin, diethyl zinc, tetraethyl lead, dimethyl (2,4-pentanedionate), gold (II) and nickel carbonyl.

Volatile palladium compounds are preferred for use in the present invention and may include, by way of example, palladium (II) 1,1,1,5,5,5-hexafluoro-2,4-pentanedionate, palladium (II) 2,4-pentanedionate, palladium (II) heptafluorodimethyloctanedionate and palladium (II) trifluoro-2, 4-pentanedionate. Palladium (II) 1,1,1,5,5,5-hexafluoro-2, 4-pentanedionate is particularly preferred.

Palladium compounds of the type employed in the present invention absorb radiation at a wavelength of about 250nm or about 350nm and therefore may be photochemically decomposed by a radiation source (e.g., excimer laser) which emits radiation at about these wavelengths. If the palladium compound is to be pyrolytically decomposed, the wavelength should be one which is not absorbed by the palladium compound.

The catalytic metal-containing compound (e.g., palladium compound) is deposited to a thickness sufficient to cover target area 6. The palladium metal layer should be thick enough to catalyze the electroless deposition process while at the same time be sufficiently thin so as to minimize the amount of impurities therein (e.g., 50 Å). Because electrolessly deposited metal is substantially free of impurities, low resistivity values are obtained for the finished metallized substrates (e.g., 6 x $10^{-6}$ Ωcm for copper).

The reaction is conducted at relatively low temperatures, preferably, below 150°C, most preferably in the range of from about 50 to 80°C. Low temperatures are employed to minimize contamination. Furthermore, low reaction temperatures make it possible to use low temperature plastic substrates.

Substrate 2 may have thereon a metal pad (not shown) which can be adapted to provide an interconnection with other electronic components, such as another printed circuit. The metal pad may be made from such conductive materials as aluminum, chromium, molybdenum and the like.

In another embodiment of the invention as shown in Figures 2(a)-2(c), an insulative layer 16 is positioned on the surface of substrate 2 and palladium metal 10 is deposited on insulative layer 16. Insulative layer 16 is used for dielectric isolation and/or planarization. Suitable insulative materials are known in the art and include, for example, insulative plastics such as polyimides, polysulfones, silicone polyimides, epoxies and Mylar.

Radiation may be supplied from any source capable of emitting radiation (e.g. ultraviolet radiation) sufficient to photochemically or pyrolytically decompose the volatile palladium compound. For example, an Argon laser emitting radiation at a wavelength of 257nm or 351nm can photodecompose palladium (II) 1,1,1,5,5,5-hexafluoro-2, 4-pentanedionate as indicated in Figure 3. This volatile palladium compound has absorption bands at about 257nm and 351nm under the temperature conditions of the decomposition step of the present invention (e.g., about 60°C). At these wavelengths, the radiation photochemically decomposes the palladium compound to deposit palladium metal on the substrate. Alternatively, the Argon laser can be operated at 514nm to irradiate the substrate until sufficient heat is generated at the substrate surface to pyrolytically decompose the palladium compound at the surface. Other volatile palladium compounds mentioned herein have an absorbance spectrum similar to that of palladium (II) 1,1,1,5,5,5-hexafluoro-2,4-pentanedionate and therefore can be photodecomposed at about 257nm or about 350nm as well.

Other lasers may alternatively be employed in the same manner. For example, an excimer laser, such as a KrF excimer laser, emits radiation at a wavelength of 248nm. Excimer lasers emit an intermittent pulse of radiation and the pulse energy employed for purposes of the present invention is in the range of millijoules to joules, preferably from 10 mJ/cm$^2$ to 300 mJ/cm$^2$.

As another alternative, non-laser radiation sources may be used, such as a mercury vapor lamp which emits radiation over a broad spectral range including 185nm, 194nm, 254nm and 350nm.

A variety of metals can be deposited in accordance with the invention. Preferred metals include copper, palladium, nickel, cobalt and iron. Copper is particularly preferred for electronic applications because of its excellent conductive properties. Furthermore, the metal may be easily plated to any desired thickness by employing well-known electroless plating solutions.

The following examples are for illustrative purposes only and are not meant to limit the invention as encompassed by the claims appended hereto.

EXAMPLE 1

Palladium (II)1,1,1,5,5,5-hexafluoro-2,4-pentanedionate (0.3g) was placed in a stainless steel cavity cell fitted with a quartz window. A three inch silicon wafer was also placed in the cell such that the surface of the wafer was accessible to radiation through the quartz window. The cell was evacuated by a standard vacuum pump through a stainless steel valve. The cell was then heated to 60°C and mounted on a computer controlled x-y stage for laser exposure. A CW Argon laser operating at 514nm, an energy level of 1 watt and a scan speed of 5mm/sec, was focused on the surface of the silicon wafer and activated to deposit palladium in the form of fine lines. The thickness of the palladium lines was about 50 Å. The pattern of lines was varied by moving the x-y stage and the power was varied by changing the laser intensity and scan speeds of the sample in a known manner. After laser irradiation, the cell was cooled, opened to the atmosphere and the silicon wafer immersed in an electroless copper bath (Enplace CU-402, sold by Enthone Corporation) for 2 minutes at room temperature. The sample was removed from the bath and rinsed in water.

The exposed regions where the fine lines of palladium were deposited were plated with a bright copper layer. The copper lines on the silicon wafer were about 1,000 Å thick and 8 µm wide.

EXAMPLE 2

The stainless steel gas cell was loaded and evacuated as described in Example 1 except that a polyimide film on alumina was used as the substrate. The cell was heated to 60°C and irradiated using an Argon laser operating at 351nm, an energy level of 200mW/cm$^2$ and a scan speed of 5mm/sec, to deposit palladium metal on the substrate. After exposure, the sample was removed and put in an electroless plating bath as described in Example 1 to produce fine lines of copper having a width of 12 µm and a thickness of about 1000 Å.

EXAMPLE 3

The gas cell was loaded with the same palladium compound as described in Example 1. A 1′ x 1″ quartz wafer was also loaded into the cell. The cell was evacuated and heated to 80°C and exposed to a 1 KW mercury vapor lamp for 15 minutes to produce a thin layer of palladium having a thickness of about 100 Å. The cell was cooled, and the substrate was removed and put in the electroless copper bath as described in Example 1. After 2 minutes, the sample was rinsed, leaving a bright uniform copper layer having a thickness of 2000 Å and a resistivity of about 6 x $10^{-6}$Ωcm.

EXAMPLE 4

A sample of polyimide film on a ceramic substrate (alumina) was put in the same stainless steel gas cell with the same palladium compound as described in Example 1. The cell was heated to 70°C and irradiated with one pulse from a KrF excimer laser operating at 248nm. The pulse energy was approximately 20 mJ/cm$^2$. The sample was then electrolessly plated in an Enthone CU-402 electroless plating bath to plate copper in the irradiated regions.

While only certain preferred features of the invention have been illustrated and described herein, many modifications and changes will occur to those skilled in the art. It is, therefore, to be understood that the appended claims are intended to cover all such modifications and changes as fall within the true spirit of the invention.

## Claims

1. A method of depositing metal on a substrate comprising:

(a) irradiating at least a portion of the substrate in the presence of a volatile catalytic metal-containing compound with an amount of radiation sufficient to decompose the metal-containing compound and thereby selectively deposit an amount of the catalytic metal on the substrate sufficient to instigate deposition of metal from an electroless plating solution; and

(b) contacting the catalytic metal-coated portion of the substrate with an electroless plating solution containing the metal to be deposited, to thereby deposit metal from the solution on the substrate.

2. The method of claim 1 wherein the catalytic metal-containing compound has a vapor pressure of from about 1 to about 100 Torr at a temperature below its decomposition temperature.

3. The method of claim 1 wherein step (a) is conducted at a temperature of up to 150°C.

4. The method of claim 3 wherein step (a) is conducted at a temperature of between about 50° and 80°C.

5. The method of claim 1 wherein step (a) comprises:

(a) adding the volatile catalytic metal-containing compound to a reaction vessel containing the substrate;

(b) heating the reaction vessel to a temperature below the decomposition temperature of the catalytic metal-containing compound; and

(c) irradiating the surface of the substrate to heat the substrate above the decomposition temperature of the catalytic metal-containing compound.

6. The method of claim 1 wherein the catalytic metal-containing compound comprises a volatile palladium compound.

7. The method of claim 6 wherein the volatile palladium compound comprises one of the group consisting of palladium (II) 1,1,1,5,5,5-hexafluoro-2,4-pentanedionate, palladium (II) 1,1,1-trifluoro-2,4-pentanedionate, palladium (II) 2,4-pentanedionate and palladium (II) heptafluorodimethyloctanedionate.

8. The method of claim 6 wherein the volatile palladium compound comprises palladium 1,1,1,5,5,5-hexafluoro-2, 4-pentanedionate.

9. The method of claim 1 wherein the electrolessly-plated metal comprises one of the group consisting of copper, palladium, nickel, cobalt and iron.

10. The method of claim 1 wherein the electrolessly-plated metal comprises copper.

11. The method of claim 1 wherein the substrate comprises one of the group consisting of polyimides, alumina, ceramics, silicone-polyimides, polysulfones, silicon, silicone rubber, metal and silicon dioxide.

12. The method of claim 1 wherein the substrate includes an insulative layer thereon, said metal being deposited on the insulative layer.

13. The method of claim 1 wherein step (a) comprises irradiating the substrate with laser radiation at a wavelength selected from 257nm and 351nm to thereby photochemically decompose the catalytic metal-containing compound.

14. The method of claim 1 wherein step (a) comprises irradiating the substrate with laser radiation at a wavelength of about 514nm to thereby pyrolytically decompose the catalytic metal-containing compound.

15. The method of claim 1 wherein step (a) comprises irradiating the substrate with an excimer laser at 248nm to thereby photochemically decompose the catalytic metal-containing compound.

16. The method of claim 15 wherein the laser radiation is emitted at an energy level of from about 10 $mJ/cm^2$ to 300 $mJ/cm^2$.

17. The product produced by the method of claim 1.

18. A method of depositing metal on a substrate comprising:

(a) irradiating at least a portion of the substrate in the presence of a volatile palladium compound at a temperature of up to 150°C with an amount of radiation sufficient to decompose the palladium compound and thereby deposit an amount of palladium metal on the substrate sufficient to instigate deposition of the metal from an electroless plating solution; and

(b) contacting the palladium metal-coated portion of the substrate with an electroless plating solution containing the metal to be deposited to thereby deposit the metal on the substrate.

19. The method of claim 18 wherein the palladium compound comprises one of the group consisting of palladium (II) 1,1,1,5,5,5-hexafluoro-2,4-pentanedionate, palladium (II) 1,1,1-trifluoro-2,4-pentanedionate, palladium (II) 2,4-pentanedionate and palladium (II) heptafluorodimethyloctanedionate.

20. The method of claim 18 wherein the volatile palladium compound comprises palladium 1,1,1,5,5,5-hexafluoro-2,4-pentanedionate.

21. The method of claim 19 wherein the metal to be deposited comprises copper.

22. The product produced by the method of claim 18.

G. E. DOCKET RD-17182
INVENTOR COLE etal
SHEET 1 OF 3 BY G.E.T.
INDEX 21-9323 X 098604

FIG. 1(a)

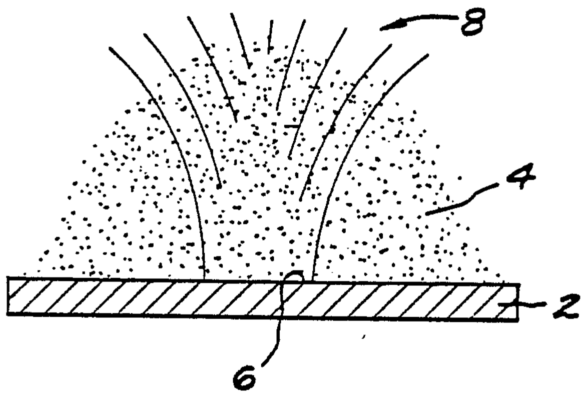


FIG. 1(b)

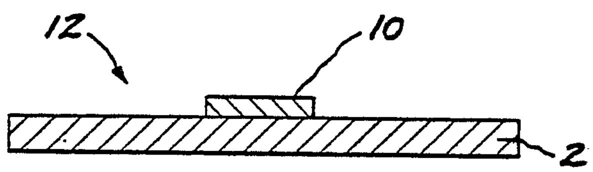


FIG. 1(c)

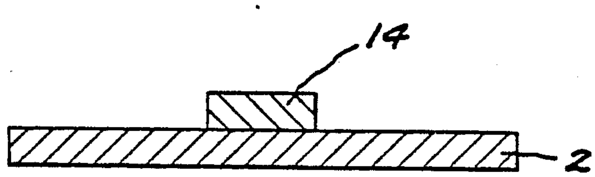

G. E. DOCKET RD-17182
INVENTOR COLE et al
SHEET 2 OF 3 BY G.E.T.
INDEX 21-9324 X 098604

FIG. 2(a)

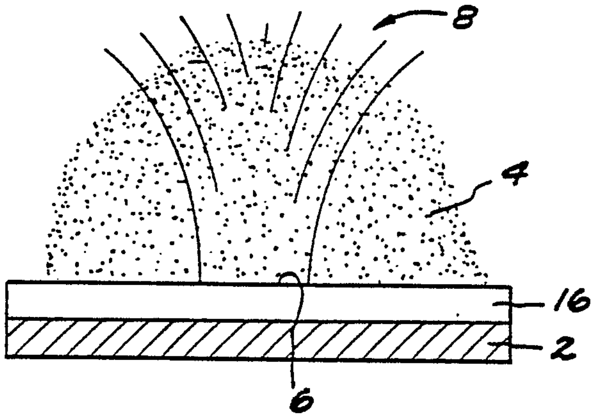


FIG. 2(b)

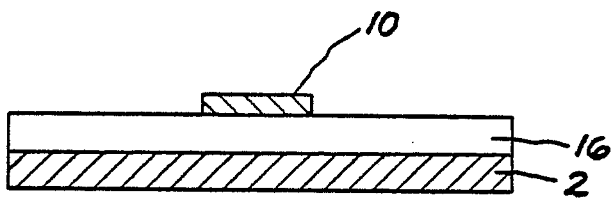


FIG. 2(c)

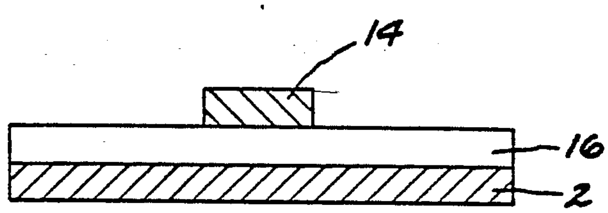

G. E. DOCKET RD-17182
INVENTOR COLE etal
SHEET 3 OF 3 BY G.E.T.
INDEX 21-9325 X 098604

FIG. 3

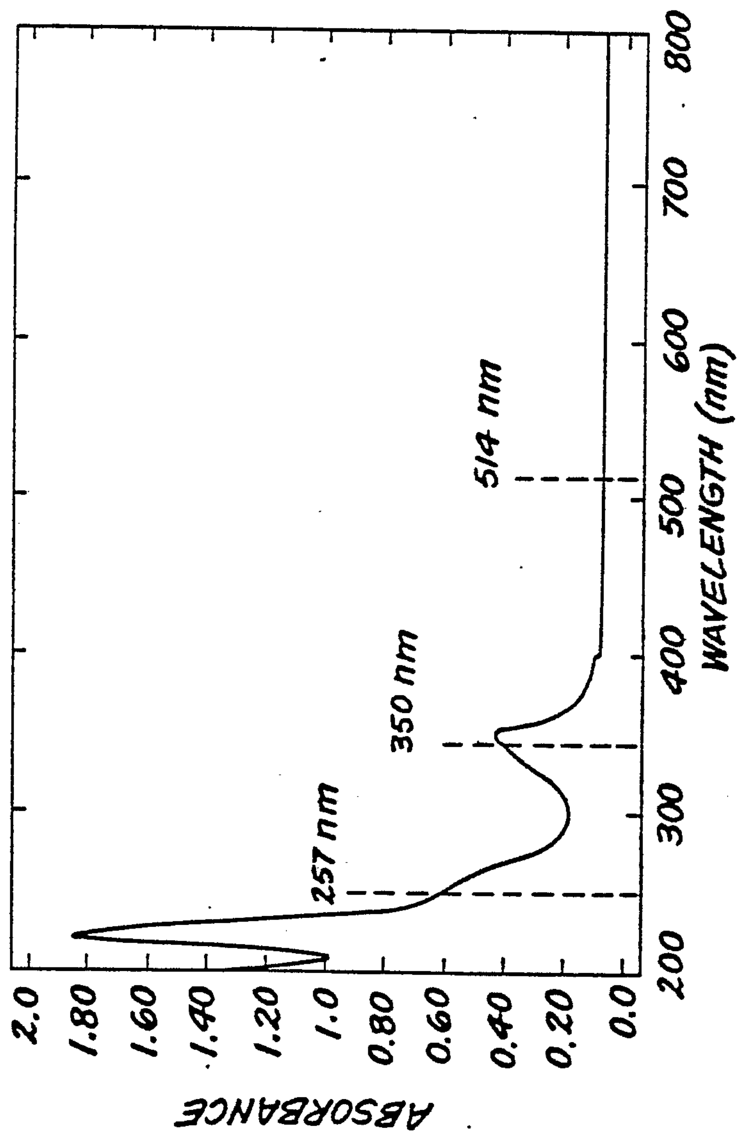

European Patent Office

# EUROPEAN SEARCH REPORT

Application Number

EP 87 11 2664

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 182 193 (IBM)<br>* Page 3; claims *<br>----- | 1,5,6,9-11 | C 23 C 18/16<br>C 23 C 18/30 |
| | | | TECHNICAL FIELDS SEARCHED (Int. Cl.4) |
| | | | C 23 C<br>H 05 K |

The present search report has been drawn up for all claims

| Place of search | Date of completion of the search | Examiner |
|---|---|---|
| THE HAGUE | 04-12-1987 | NGUYEN THE NGHIEP |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)